Europäisches Patentamt

European Patent Office

Office européen des brevets

(11) Publication number: **0 459 359 A2**

# EUROPEAN PATENT APPLICATION

(21) Application number: 91108595.9

(51) Int. Cl.⁵: **H01L 39/12**

(22) Date of filing: 27.05.91

(30) Priority: 28.05.90 JP 137595/90

(43) Date of publication of application:
04.12.91 Bulletin 91/49

(84) Designated Contracting States:
DE FR GB NL

(71) Applicant: TODA KOGYO CORP.
7-1 Yokogawa-Shinmachi Nishi-ku
Hiroshima-shi Hiroshima-ken(JP)

Applicant: NEC CORPORATION
7-1, Shiba 5-chome Minato-ku
Tokyo 108-01(JP)

Applicant: SEISAN KAIHATSU KAGAKU
KENKYUSHO
15, Shimogamo Morimoto-cho
Sakyo-ku Kyoto-shi Kyoto-fu(JP)

(72) Inventor: Takada, Toshio
1, Nishisenouchi-cho, Kitashirakawa
Sakyo-ku, Kyoto-shi, Kyoto-fu(JP)
Inventor: Takano, Mikio
17, Yasuihigashiura-cho, Uzumasa
Ukyo-ku, Kyoto-shi, Kyoto-fu(JP)
Inventor: Miura, Yoshinari
1155, Takeman, Kamigoori-cho
Ako-gun, Hyogo-ken(JP)
Inventor: Takada, Jun
1-1410, Shimizu
Okayama-shi, Okayama-ken(JP)
Inventor: Yamamoto, Naoichi
D-17-203, Satakedai Haitu, 1-2, Satakedai
Suita-shi, Osaka-fu(JP)

(74) Representative: Vossius & Partner
Siebertstrasse 4 P.O. Box 86 07 67
W-8000 München 86(DE)

(54) **Bi-Pb-Sr-Ca-Cu-O system superconductors.**

(57) A Bi-Pb-Sr-Ca-Cu-O system superconductor having a composition of

$$Bi_nPb_mSr_xCa_yCu_2$$

wherein n is a number larger than 0.75 and not larger than 1.15, m is a number from 0.25 to 0.35, x is a number from 1.20 to 1.35 and y is a number from 1.20 to 1.35, when they are normalized with the Cu mole number of 2, which has $T_c$ of at least 108 K.

Fig. 1

The present invention relates to Bi-Pb-Sr-Ca-Cu-O system superconductors which have a zero resistance critical temperature ($T_c$) of at least 108 K, preferably at least 110 K.

In 1988, the researchers in the National Institute for Metals, Japan found a Bi-Sr-Ca-Cu-O system superconductor having $T_c$ of 105 K which was obtained by extrapolation of the measured date. However, hitherto, it has been believed that it is very difficult to produce a Bi-Sr-Ca-Cu-O system superconductor which has $T_c$ of 105 K or higher and contains a high $T_c$ phase in a large volume percentage with good reproducibility.

The present inventors synthesized a superconductor comprising a Bi-Sr-Ca-Cu-O system to which Pb is added and found that such new Bi-Pb-Sr-Ca-Cu-O system superconductor had $T_c$ of 107 K. However, it is still difficult to produce the Bi-Pb-Sr-Ca-Cu-O system superconductor having $T_c$ of 107 or higher and containing the high $T_c$ phase in a larger volume percentage with good reproducibility. Very few scientists have been able to synthesize such superconductor.

The Y-Ba-Cu-O system superconductor which was found in 1987, the Bi-Sr-Ca-Cu-O system superconductor and the Bi-Pb-Sr-Ca-Cu-O system superconductor have $T_c$ higher than the liquid nitrogen temperature, namely 77 K and attract great attention worldwidely. But, it is still desired to provide a superconductor having higher $T_c$ since when difference between the liquid nitrogen temperature and $T_c$ is greater, the superconductor has better and more stable superconductive characteristics.

One object of the present invention is to provide a Bi-Pb-Sr-Ca-Cu-O system superconductor having higher $T_c$.

Another object of the present invention is to provide a Bi-Pb-Sr-Ca-Cu-O system superconductor which can be synthesized with good reproducibility.

These and other objects are achieved by a Bi-Pb-Sr-Ca-Cu-O system superconductor having a composition of

$$Bi_nPb_mSr_xCa_yCu_2$$

wherein n is a number larger than 0.75 and not larger than 1.15, m is a number from 0.25 to 0.35, x is a number from 1.20 to 1.35 and y is a number from 1.20 to 1.35, when they are normalized with the Cu mole number of 2.

Fig. 1 is a graph showing the temperature dependence of the electrical resistance of the sample prepared in Example 1,

Fig. 2 shows the X-ray diffraction pattern of the sample prepared in Example 1, and

Fig. 3 shows the A.C. magnetic susceptibility of the sample prepared in Example 1.

The Bi-Pb-Sr-Ca-Cu-O system superconductor of the present invention has a composition of

$$Bi_nPb_mSr_xCa_yCu_2$$

wherein n is a number larger than 0.75 and not larger than 1.15, m is a number from 0.25 to 0.35, x is a number from 1.20 to 1.35 and y is a number from 1.20 to 1.35, when they are normalized with the Cu mole number of 2.

The superconductive compound of the present invention can be produced as follows:

First, as raw materials, $Bi_2O_3$, $SrCO_3$, $CaCO_3$, CuO and PbO are weighed in a desired molar ratio and mixed, or carboxylates such as oxalates containing Bi, Pb, Sr, Ca and Cu in a desired molar ratio are synthesized by a coprecipitation method. In this step, the molar ratio of Bi, Sr, Ca and Cu may be almost the same as that in the final product, while Pb may be used in a ratio more than that in the final product since a part of Pb is evaporated during thermal treatment.

When the mole number of Cu is 2, the preferred molar ratios of other elements in the raw material are

$0.76 < n < 1.20$,

$0.25 < m < 0.80$,

$1.15 < x < 1.40$ and

$1.15 < y < 1.40$.

Then, the oxide mixture or the carboxylate mixture is heated and reacted in the air at about 800°C. When the carboxylates are used, preferably the mixture is thermally decomposed at about 250°C and then reacted at about 800°C. The heated mixture is ground and pelletized under pressure of about 500 to 1000 kg/cm². Finally, the pellet is sintered at a temperature of 845 to 865°C.

The present invention will be illustrated by following Examples.

Example 1

To a solution of nitrates of Bi, Pb, Sr, Ca and Cu, ammonium oxalate was added to coprecipitate oxalates in which the molar ratio of Bi:Pb:Sr:Ca:Cu was 0.77:0.55:1.24: 1.33:2.00. The coprecipitated oxalates were dried at 100°C, heated at 500°C to decompose them and ground followed by heating with an electric furnace in the air at 800°C for 12 hours. Thereafter, the mixture was again ground and pressed under pressure of about 600 kg/cm² to produce a pellet of 20 mm in diameter and 2 mm in thickness. The pellet was sintered with the electric furnace in the air at 850°C for 24 hours. Then, grinding, pressing and formation of a pellet were repeated and again the pellet was sintered with the electric furnace in the air at 850°C for 80 hours.

With the sintered sample, the molar ratio of the component elements was examined with ICAP to find that the molar ratio of Bi:Pb:Sr:Ca:Cu was 0.725:0.332:1.218:1.295: 2.00 when normalized with the mole number of Cu of 2.

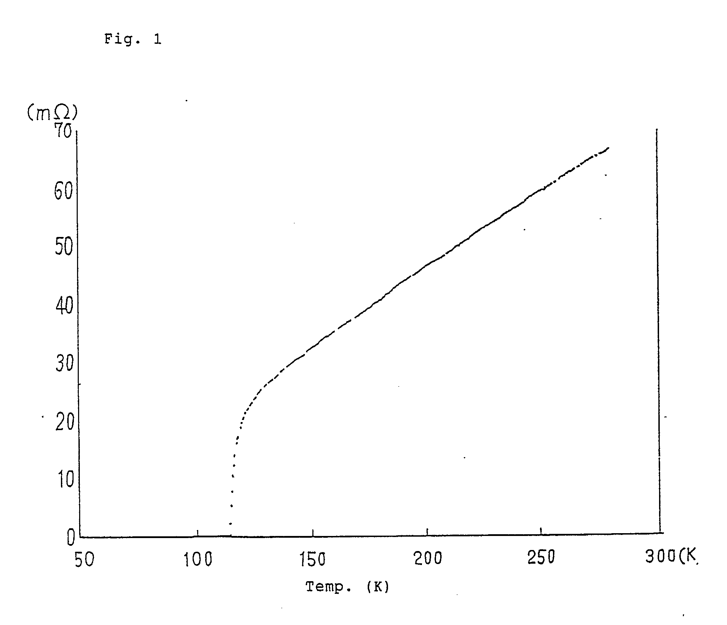

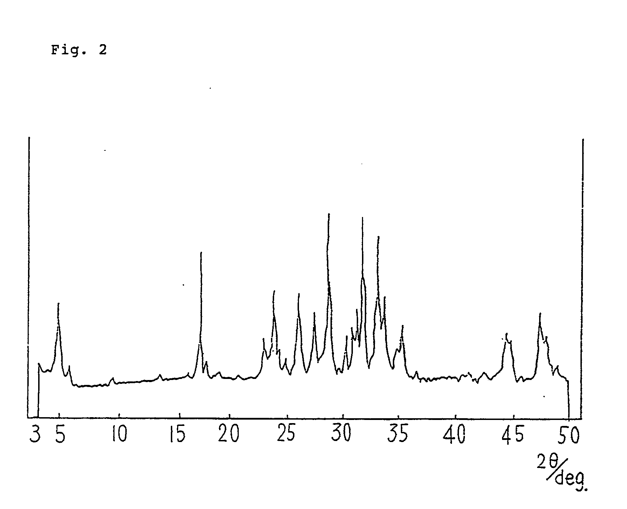

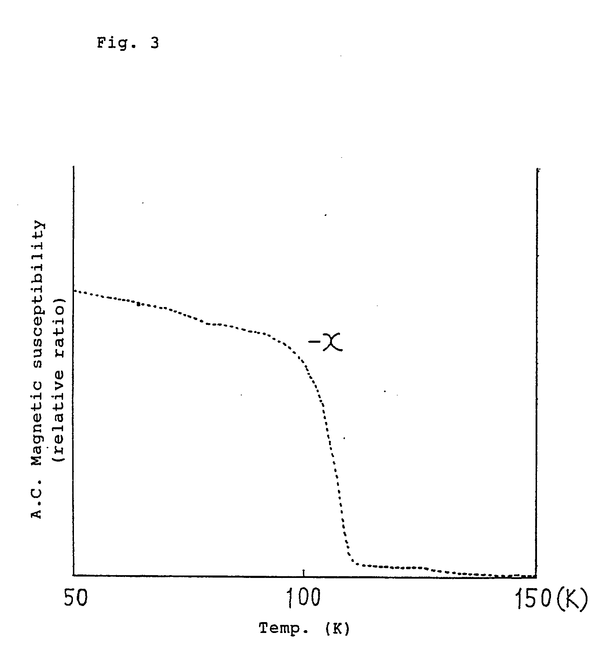

The temperature dependence of the electrical resistance of this sample is shown in Fig. 1, from which it is understood that the electrical resistance quickly dropped from about 130 K and reached 0 (zero) at about 112 K. The A.C. magnetic susceptibility of this sample is shown in Fig. 3, which confirms that this sample could be superconductive at about 112 K or higher. The X-ray diffraction pattern of this sample is shown in Fig. 2, which indicates that the percentage of the high $T_c$ phase with the c axis of 37 Å in this sample was about 70 %.

Example 2

In the same manner as in Example 1 but coprecipitating oxalates in which the molar ratio of Bi:Pb:Sr:Ca:Cu was 1.19:0.41:1.24: 1.34:2.00 and carrying out the last sintering at 850°C for 72 hours, a superconductive oxide in which a molar ratio of Bi:Pb:Sr:Ca:Cu was 1.140:0.261:1.233:1.288:2.00 was produced. This sample had a zero resistance critical temperature of about 110 K, the X-ray diffraction pattern of this sample indicated that the percentage of the high $T_c$ phase was about 70 %.

**Claims**

1.  A Bi-Pb-Sr-Ca-Cu-O system superconductor having a composition of

    $Bi_nPb_mSr_xCa_yCu_2$

    wherein n is a number larger than 0.75 and not larger than 1:15, m is a number from 0.25 to 0.35, x is a number from 1.20 to 1.35 and y is a number from 1.20 to 1.35, when they are normalized with the Cu mole number of 2.

Fig. 1

Fig. 2

Fig. 3